(19) Europäisches Patentamt / European Patent Office / Office européen des brevets

(11) **EP 1 701 171 B1**

(12) **EUROPEAN PATENT SPECIFICATION**

(45) Date of publication and mention
of the grant of the patent:
**23.04.2008 Bulletin 2008/17**

(51) Int Cl.:
*G01R 31/00* (2006.01)

(21) Application number: **06002655.6**

(22) Date of filing: **09.02.2006**

(54) **Solid state absorbing clamp**

Festkörper-Absorptionsklemme

Pince absorbante à l'état solide

(84) Designated Contracting States:
**DE GB**

(30) Priority: **11.03.2005 SG 200501532**

(43) Date of publication of application:
**13.09.2006 Bulletin 2006/37**

(73) Proprietor: **Rohde & Schwarz Systems & Communications Asia Pte. Ltd.
Singapore 415941 (SG)**

(72) Inventor: **Gielen, Herman
Singapore 298127 (SG)**

(74) Representative: **Körfer, Thomas et al
Mitscherlich & Partner
Patent- und Rechtsanwälte
Postfach 33 06 09
80066 München (DE)**

(56) References cited:
**GB-A- 2 359 934      US-A- 5 477 154**

• **YU CHAI ET AL: "Automatic measurement system of the disturbance power of household electrical appliances and electric facilities" ELECTROMAGNETIC COMPATIBILITY, 2002 3RD INTERNATIONAL SYMPOSIUM ON MAY 21-24, 2002, PISCATAWAY, NJ, USA,IEEE, 21 May 2002 (2002-05-21), pages 211-213, XP010630597 ISBN: 0-7803-7277-8**
• **ANONYMOUS: "Calibration and use of artificial mains networks and absorbing clamps/ Proper use of transducers for CISPR-based emission measurements" [Online] 25 February 2004 (2004-02-25), INTERNET ARTICLE , XP002380020 Retrieved from the Internet: URL:http: //web.archive.org/web/20040225215 529/http: //www.elmac.co.uk/ff26_dl.htm> [retrieved on 2006-05-05] * figures 29,31-34,36 * * page 30 - page 57 ***

**Description**

**FIELD OF THE INVENTION**

The present invention relates to measurement of electrical and/or electromagnetic interference particularly though not solely to an apparatus for testing power disturbance.

**BACKGROUND TO THE INVENTION**

It is well known in the art that for an electrical appliance to be sold in a given jurisdiction it must comply with various standards. Over recent times one of the most important has become Electromagnetic Compliance (EMC) or the level to which the appliance interferes electromagnetically (radiated) or electrically (conducted) with other appliances.

One method of measuring radiated electromagnetic emissions is to simply provide an antenna in proximity to the "Equipment Under Test" (EUT) and analyze the output. Another common method is the use of an "absorbing clamp". This works on the principal that the primary source of high frequency emissions is the signal that is coupled onto a connected cable from interference generated within the EUT. Then, an indication of the disturbing capability of the EUT is obtained by measuring the current that is fed in common-mode onto this cable, and which will be coupled away from the cable by radiation. The assumption is valid for many types of apparatus that have only one cable (typically the mains cable) and whose dimensions are small compared to a wavelength. When the equipment has several connected cables, or when its dimensions are greater than a quarter wavelength (that is, it is physically large, and/or the frequency of interest is high) the assumption is harder to justify and a radiated test is preferred. Nevertheless this measurement method has a good record as a means of assessing the interference potential of many types of equipment, and it is generally simpler to carry out than the radiated method.

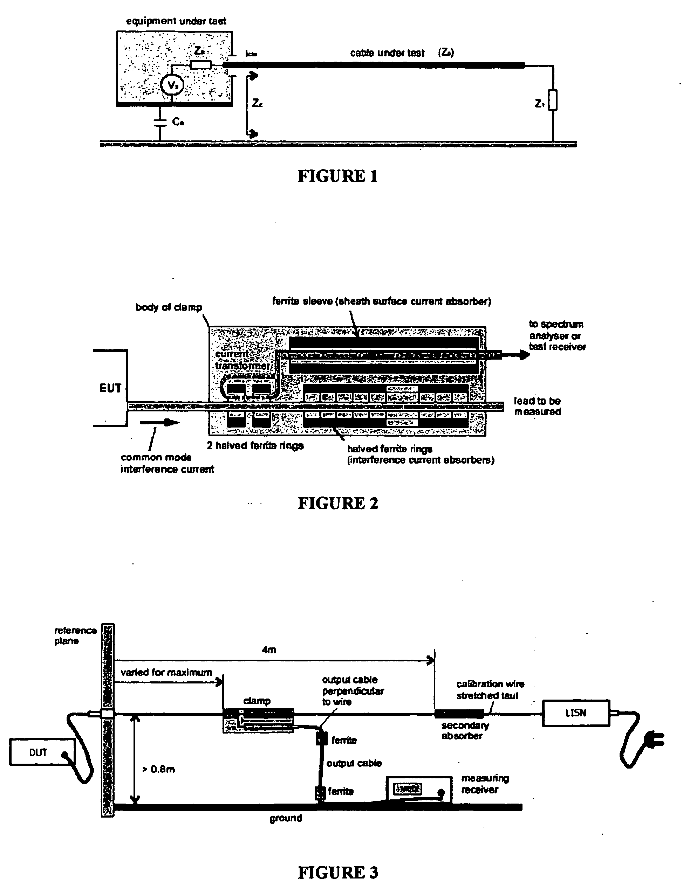

The equivalent circuit for high frequency emissions in the standard absorbing clamp test set-up is shown in Figure 1. A length (normally >5m) of the cable under test is stretched out at a constant height above ground and thus forms a transmission line of characteristic impedance $Z_0$, a value which is determined by the geometry of the set-up as shown in Figure 3. The far end of this cable is terminated in an impedance $Z_T$, which is generally unknown, being fixed by the high frequency impedance of the mains supply or the ancillary equipment which may be connected. (Placing a second absorber at this end stabilizes $Z_T$, as discussed later.) The impedance presented to the EUT is $Z_C$, which is the transmission line impedance $Z_0$ modified by $Z_T$ and any other mismatches that are present on the line.

The disturbing source in any EUT can be represented by a voltage source $V_s$ in series with an impedance $Z_s$, referred to the enclosure (this simplification is valid whether or not the equipment has a Class II insulated or Class I earthed metal enclosure). Of course, both Vs and $Z_s$ are frequency dependent. $Z_s$ is coupled in common mode to the cable under test - that is, the resulting current $I_{CM}$ flows equally and in the same sense in all conductors in the cable. The mechanism of coupling depends on the design detail and may be complicated, but need not concern this discussion. The EUT is isolated from the ground but coupled to it via stray capacitance $C_s$, which is a function of the equipment's geometry and its distance from the floor and other surrounding objects.

Matching considerations dictate that the maximum power transfer from the EUT to the cable will occur when

$$Re(Z_C) = Re(Z_S + 1/j\omega C_S)$$

$Z_s$ and $C_s$ are fixed by the EUT and the set-up, so power matching can be achieved by varying $Z_C$. This is the purpose of applying the clamp to the cable and moving it through a half wavelength, as discussed below.

The absorbing clamp as defined in clause 13 of CISPR 16-1 has three principal features as shown in Figure 3. Firstly a loop of coaxial cable wound round two or three ferrite rings, which acts as a current transformer, inducing a signal into the loop from any RF current which flows through the cable under test to which the ferrite rings are coupled. Secondly an absorbing section made up of a further cascade of ferrite rings, located further down the cable under test away from the emitting source, whose purpose is to stabilize the RF common-mode impedance of the cable under test and reduce its dependence on the far-end termination. And thirdly a further section of absorber over the sheath of the cable leading from the current transformer, which increases the common mode impedance of this cable and thereby reduces the impact of any variations in this impedance which may be coupled via stray capacitance through the transformer to the cable under test.

The ferrite rings are halved, and the clamp is so hinged that the cable under test can be laid through the whole assembly and the other halves brought down to enclose it completely. Good mating between the halves is essential and the ferrite housings are sprung to ensure this. Typically, the ferrites are mounted in the body of the clamp which is made of insulating material; there are no galvanic connections to be made either to the cable under test or to the transducer output cable.

In use, the clamp is placed round the cable under test with the current probe facing the emitting source. The far end of the cable is connected to the mains supply or to ancillary equipment, or left open in calibration; a second absorber may be placed over the lead. The clamp output is connected to the measuring receiver or spectrum analyzer.

To determine the maximum power that the disturbing source can deliver to a lead of indeterminate length, the clamp is moved along the cable under test to find a maximum at any given frequency. The output level varies periodically with distance, the distance between peaks being around half the wavelength of the measured frequency. The horizontal cable is acting against the ground as a transmission line, on which current standing waves are induced, and the clamp is measuring these standing waves. For a standing wave to form there must be a mismatch along the transmission line. Such a mismatch will be caused by either of two sources:

· the termination (or lack of it) at the end of the line, or
· the absorbing clamp itself.

If the absorbing section of the clamp is fully effective, the end of line termination should be invisible to the line between the clamp and the disturbing source, and should not therefore contribute to the standing wave measured by the current transformer. Nevertheless, the absorber itself will be mis-matched with respect to the transmission line impedance and will therefore cause a reflection, which in turn creates a standing wave. The current transformer is fixed in relation to the absorber and therefore remains at the same point on the standing wave, yet still senses a periodic variation in output; this is because as the clamp is moved, the amplitude of the signal fed to the cable varies, because the impedance presented to the disturbing source is varied. Therefore, moving the clamp will present an envelope of load impedances to the source which will allow, within limits, the maximum power transfer to be achieved.

Commercially available absorbing clamps typically must be moved over a length of at least 5 meters over a power cable of the EUT. This can be done manually however since the test takes a considerable amount of time in practice the absorbing clamp is often installed on a mechanical glide rail controlled by an electric motor.

It would be desirable to provide a device which does not require mechanical movement. It would also be desirable to have a smaller overall size of test setup. It would be further desirable to have a faster test procedure, with less time invested in setting up or assembling the test apparatus.

Document GB-A-2 359 934 discloses a noise absorbing filter for assembly around a cable, which absorbing filter can be switched between two filter operating modes to adjust the impedance induced in the cable.

## SUMMARY OF THE INVENTION

It is therefore an object of the present invention to achieve any of the above desideratum, to overcome any disadvantages in the prior art or which will at least provide the public with a useful choice.

Accordingly in a first aspect the present invention consists in a system for measuring power disturbance generated by a piece of equipment the system comprising:

an electrical cable configured for connecting said equipment to a power source;
a plurality of transformers positioned along the length of said cable;
a plurality of switching devices each configured to connect the secondary winding of a respective transformer to either an open circuit, a short circuit or to current measurement or analysis means;
whereby when an operative switching device connects the secondary winding of operative transformer to said current measurement or analysis means, each switching device on a first side of said operative switching device connects the secondary winding of the respective transformer as short circuit and each switching device on the other side of said operative switching device connects the secondary winding of the respective transformer as open circuit.

Preferably a system further comprising:

control means operative connected to said plurality of switching devices configured to automatically switch each switching devices in a predetermined sequence to sequentially connect all of the secondary windings of said plurality of transformers to said current measurement or analysis means.

Preferably said first side corresponds to the side connected to said equipment.

Preferably a system further comprising a housing enclosing said cable, said plurality of transformers and said plurality of switching devices.

Preferably said cable and said plurality of transformers are arranged in a serpentine spiral or coiled configuration within said housing.

Preferably said current measurement or analysis means comprising:

a spectrum analyzer or test receiver, and
wherein said current measurement or analysis means, said spectrum analyzer or said test receiver including an input resistance, and
wherein the voltage across said input resistance thereby allowing measurement or analysis of the current in said cable.

Preferably said plurality of switching devices comprising a plurality of semiconductor switches or switch packages.
Preferably said semiconductor switches or switch packages are MOSFET semiconductors.
Preferably said semiconductor switches or switch package are GaAs switches.
Preferably said predetermined sequence comprises a pre-scan using a first of said transformers and a full scan over all of said plurality of transformers.
Preferably said pre-scan including said spectrum analyzer of test receiver determining peak frequencies of power disturbance and said full scan including said spectrum analyzer or test receiver recording the frequency spectrum of said power disturbance between 10MHz and 1GHz.
To those skilled in the art to which the invention relates, many changes in construction and widely differing embodiments and applications of the invention will suggest themselves without departing from the scope of the invention as defined in the appended claims. The description herein is purely illustrative and not intended to be in any sense limiting.
The invention consists in the foregoing and also envisages constructions as defined in the claims of which the following gives examples only.

**BRIEF DESCRIPTION OF THE DRAWINGS**

Preferred forms of the present invention will now be described with reference to the accompanying drawings in which;

**Figure 1** shows the equivalent circuit of a prior art absorbing clamp;
**Figure 2** shows a cross section of a prior art absorbing clamp;
**Figure 3** shows the apparatus setup for a prior art power disturbance testing;
**Figure 4** is a diagram representation of the present invention;
**Figure 5** is a diagrammatic representation of the serpentine shape of the power cord and ferrites;
**Figure 6** is a diagrammatic representation of the operative transformer connected to the input resistance of the test instrument;
**Figure 7** is a diagrammatic representation of the switches connected to the control circuit;
**Figure 8** is a cross section of the different ferrite spacing embodiments.
**Figure 9** is a graph of the impedance of the present invention or frequencies of interest.
**Figure 10** is a circuit diagram of the switching configuration.
**Figure 11** is an equivalent AC circuit of the switching configuration.
**Figure 12** is an example graph of insertion loss.
**Figure 13** is an example graph of isolation loss.
**Figure 14** is a cutway showing the internal constructions.
**Figure 15** is a graph showing the drive signals for the switches.
**Figure 16** is a schematic of 50mm ferrite spacing; and
**Figure 17** is a schematic of 16mm ferrite spacing.

**DETAILED DESCRIPTION**

Instead of moving the current probe over the total length of the power cord in the present invention ferrite beads (or toroidal magnetic core) are fitted over the entire length of an artificial power cord and a secondary winding is provided on each ferrite bead. So instead of "mechanically moving" the current clamp over the power cord we "electrically move" the position of current measurement or analysis. This method however introduces some new issues:

(1) The ferrites "in front" of the one operating as a current probe act as chokes. This attenuates the disturbance signal as they act as an EMI suppressor. Since it is the disturbance level that we want to measure. This is exactly what we don't want to happen.
(2) The ferrites "behind" the ferrite that functions as a current probe could accidentally function as terminator. In order to make the end of the line "invisible" to the disturbance source these beads must precisely function as chokes i.e. pose impedance as high as possible.

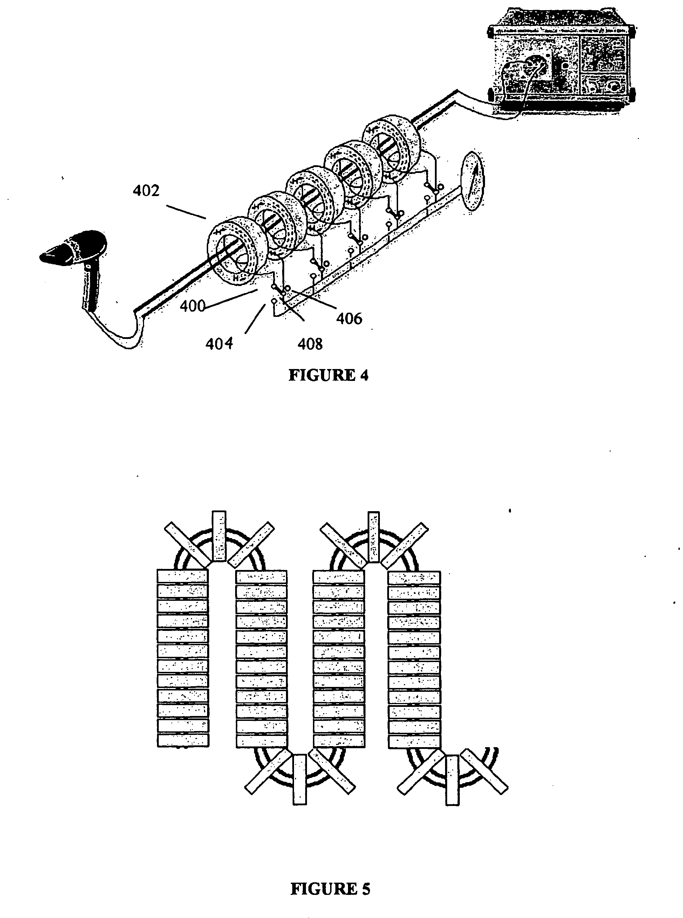

In the mechanical absorbing clamp a ferrite has only one single role either choke or current transformer. To overcome those issues above in the present invention each ferrite 402 has three roles depending on the position of the switch 400 as shown in Figure 4 i.e.

(1) Invisible (position 404).
(2) Choke (position 406).
(3) Current transformer (position 408).

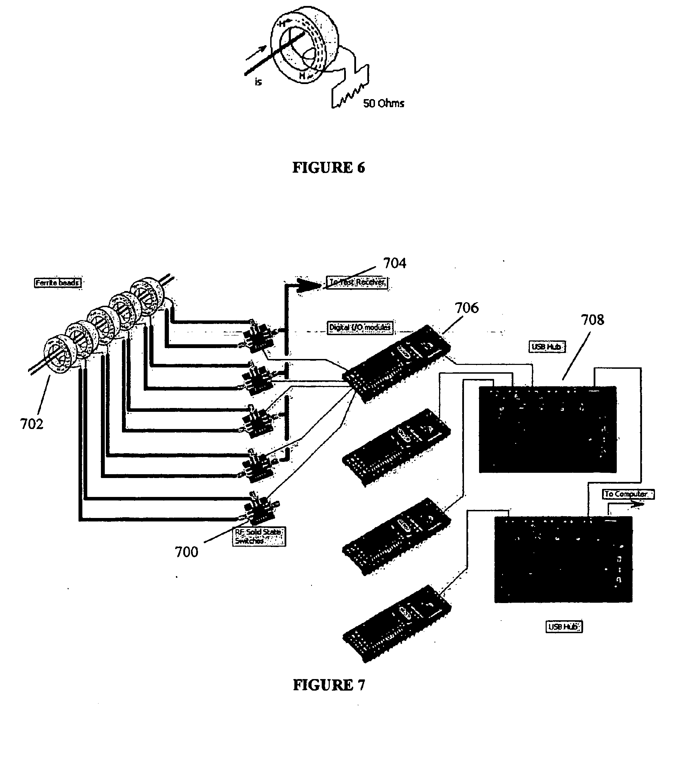

In Figure 7 each switch 700 is shown connected to a transformer 702, the test receiver 704 and a digital I/O module 706 which provides the switching drive signal. The digital I/O module 706 in turn is connected to and controlled by controller 708, preferably a personal computer or a microcontroller.

1: The "Invisible" mode is based on the fact that the secondary impedance is transposed to the primary as follows:

The following relationship exists in a transformer:

$$\frac{Ns}{Np} = \frac{Vs}{Vp} \text{ or } \frac{Ns}{Np} = \frac{\sqrt{Ps.Zs}}{\sqrt{Pp.Zp}}$$

Assumption a perfect transformer and power transfer we can simplify the formula.

$$\frac{Ns}{Np} = \sqrt{\frac{Zs}{Zp}} \text{ or } Zp = Zs.\left(\frac{Np}{Ns}\right)^2$$

It is obvious that if Zs is zero Zp is zero as well. So by shorting the secondary winding the effect of the ferrite inside the transmission line is theoretically nil. In reality preliminary tests with 12 ferrite cores show the following results:

| Frequency MHz | Generator Level (dBm) * | Shorted secondary winding (dBm) |
|---|---|---|
| -100.0 | -50.0 | -50.0 |
| 100.0 | "" | -50.0 |
| 200.0 | "" | -51.0 |
| 300.0 | "" | -52.0 |
| 400.0 | "" | -53.0 |
| 500.0 | "" | -56.0 |
| 600.0 | "" | -56.0 |
| 1000.0 | "" | -56.0 |
| * The generator level is the calibrated level pick up by the spectrum analyzer through the current probe. | | |

Especially for frequencies above 300 MHz the effectiveness of the shorting gets worse. Preferably short wires are used together with tuning and proper reduction of stray capacitances and inductances in the wiring.
2: In "Choke" mode we open the switch. In this case the impedance of the ferrite is determined by its equivalent circuit or RCL circuit. The initial test showed no difference between an open secondary winding and no winding at all on the ferrites. In our test set-up we used a mechanical switch, although a solid state switch still provides adequate performance.

| Frequency MHz | Generator Level (dBm) * | shorted open secondary winding (dBm) |
|---|---|---|
| 100.0 | 50 | -53.0 |
| 200.0 | "" | -56.0 |
| 300.0 | "" | -56.0 |
| 400.0 | "" | -56.0 |
| 500.0 | "" | -56.0 |
| 600.0 | "" | -56.0 |
| 1000.0 | "" | -56.0 |

3: In 'Current transformer mode" The ferrite functions as a regular current transformer. The current flowing in the transmission line is terminated into a 50 ohms load i.e. the terminator of the measurement instrument as shown in Figure 6 to allow measurement or analysis.

The 3 above-mentioned modes can replace the 2 different ferrite cores in the mechanical glide rail clamp.

- In "Current transformer mode" the ferrites perform the same function as the 2 or 3 core current transformer at the outer edge of the clamp.
- In "absorber" mode with the transformer open circuited the ferrites isolate the end of the transmission line to ensure the formation of a standing wave. This mode is necessary to replace the 2nd ferrite clamp.
- In "Invisible" mode with the transformer short circuited we can switch off i.e. logically remove the ferrites from the cord. This is required for the sections between the EUT and the current transformer ferrite.

To replace the mechanical movement of the "Current transformer" we follow a switching pattern.

| Fe 1 | Fe 2 | Fe 3 | Fe 4 | Fe 5 | Fe 6 | Fe 7 | Fe 8 | Fe 9 | Fe10 |
|---|---|---|---|---|---|---|---|---|---|
| Ct | Ch | Ch | Ch | Ch | Ch | Ch | Ch | Ch | Ch |
| In | Ct | Ch | Ch | Ch | Ch | Ch | Ch | Ch | Ch |
| In | In | Ct | Ch | Ch | Ch | Ch | Ch | Ch | Ch |
| In | In | In | Ct | Ch | Ch | Ch | Ch | Ch | Ch |
| In | In | In | In | Ct | Ch | Ch | Ch | Ch | Ch |
| In | In | In | In | In | Ct | Ch | Ch | Ch | Ch |
| In | In | In | In | In | In | Ct | Ch | Ch | Ch |
| In | In | In | In | In | In | In | Ct | Ch | Ch |
| In | In | In | In | In | In | In | In | Ct | Ch |
| In | In | In | In | In | In | In | In | In | Ct |
| Fe = Ferrite, Ct = Current transformer mode, Ch = Choke mode, n = Invisible mode | | | | | | | | | |

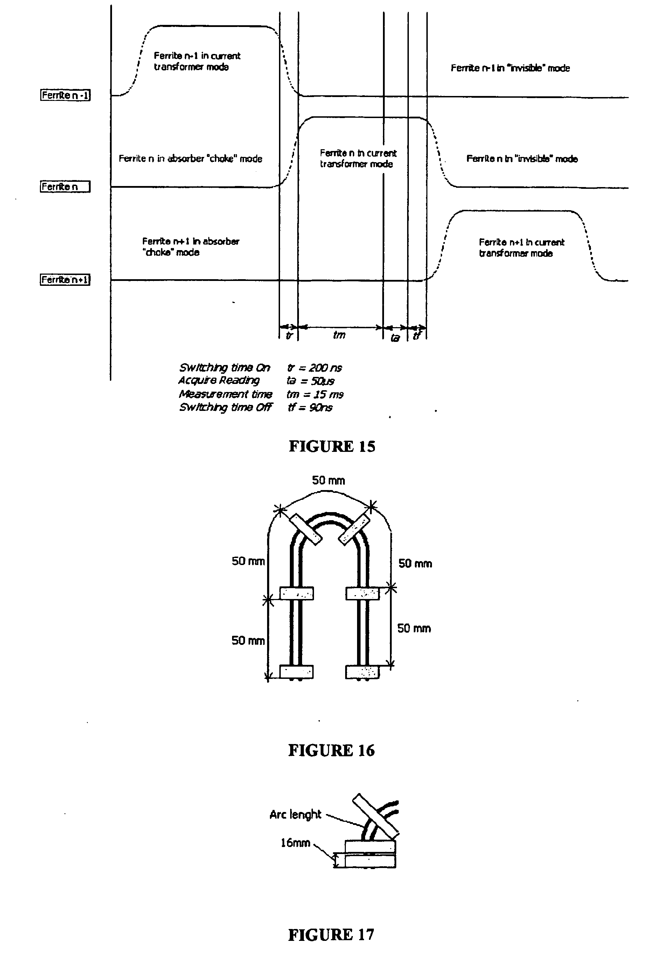

To make all the necessary switching in the preferred embodiment of the present invention MOSFET solid state switches are used. Although mechanical RF relays are fast enough to get an acceptable performance the constant switching will have a considerable impact on the wear and thus reliability of the relays. Referring to Figure 15 the switching sequence is shown there is a transition period between ferrities. For each ferrite there is a measurement period then acquisition.

**Internal Construction**

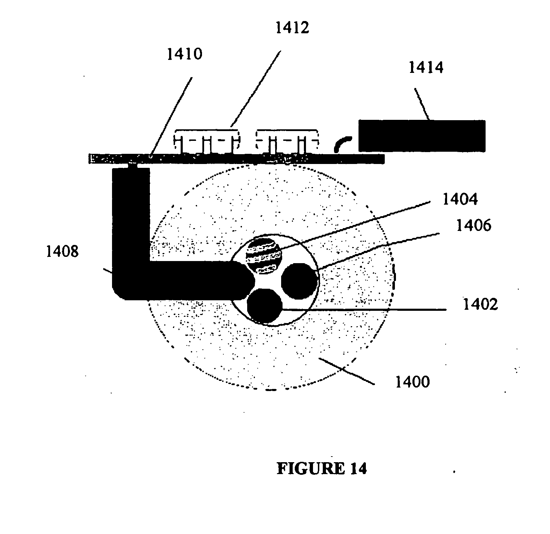

Referring to Figure 14, the internal construction is shown with the annular ferrite bead or torroid 1400 having an interior diameter to accommodate the cables. The cables include the live wire or cable under test (UB) 1402, an earth wire 1404, and a neutral wire 1406. A secondary winding 1408 around the bead 1400 is connected through a PCB 1410

6

to switches 1412 ultimately to the receiver 1414. This is all encased in an enclosed package (not shown).

**Ferrite Parameters**

a) Mechanical Requirements

The spacing between the ferrites is a tradeoff: Weight versus measurement resolution.
The best measurement resolution is obtained when the entire length of the power cord is covered with infinitely small ferrites. In reality ferrites with a width of 15mm are adequate.

- To fulfill the electro-magnetic requirements, appropriate ferrites would have a cross section of around 100mm$^2$ or more. This is necessary to meet the impedance requirements defined in CISPR16-1. See next paragraph.
- To pass the EUT power cord we assume a boring of 20 mm allowing easy passage of power cord of diameters up to 16mm.

The above assumptions give us the following situation: To cover the entire 5m with ferrites of this dimension (to obtain maximum measurement resolution) means that we need around 333 pieces. With a ferrite density of 4500kg/m$^3$ - 5500 kg/m$^3$ the total weight would mount up to approx. 15kg (approx. 43g x 333), including casing and electronics easily 20kg. Such a probe becomes impractical especially as preferably the probe is "portable" The following factors reduce the weight.

(1) The larger the spacing between ferrities the less likely the clamp would gain acceptance as an "official" tool for disturbance power measurements. However the concept would still gain wide acceptance in pre-compliance testing. At least if the spacing isn't too large. In a commercially viable device the distance between from the ferrite to another should be no larger than 100mm. Preferably the spacing is between 16mm and 50mm as se. More preferably the spacing is 30mm.
(2) The weight of the ferrites is determined by: V. ρ (V = Volume, ρ = Density) Little can be done to reduce the density so in practice the volume can only be reduced by reducing the volume i.e. diameter & cross section of the ferrite bead. Reducing the cross section has its limits as well since the impedance (electromagnetic) requirements need to be fulfilled.

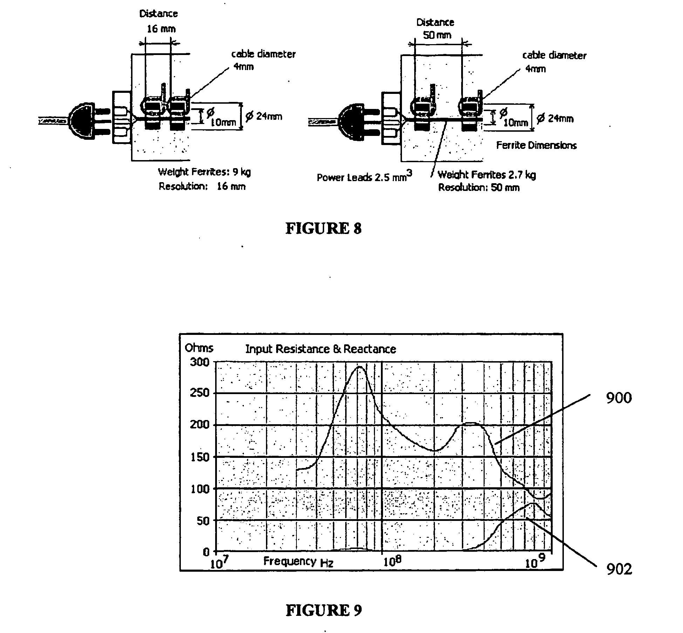

This leaves us with the diameter. Since the power cord can be fixed permanently inside the ferrites we can reduce the diameter considerably with respect to the existing mechanical clamp concept. If we set the maximum EUT current rating at 20A or 4.4KVA for a 220V line voltage 2.5mm$^3$ wires are sufficient.
A 2.5mm$^3$ wire has a diameter of around 4mm. The RF cable used to make the RF pickup coil has an outer diameter of 4 mm as well. To fit 4 wires (RF cable, L,N, and Earth) the boring must be 10mm. The outer diameter then would be around 24mm as seen in Figure 8. A simple calculation teaches us that such a ferrite weighs around 27 grams. A reduction in weight of approx 37%.

b) Electromagnetic Ferrite Requirements

The ferrite material presents an impedance on the cable which is complex (both resistive and inductive components) and varies with frequency.
The CISPR 16-1 requirement is that the clamp as a whole should present an impedance between 100 Ω and 250 Ω, not more than 20% reactive, when measured in the standard calibration set-up with the signal generator and 10dB attenuator.
Figure 9 shows the input impedance (Resistive 900 & Reactive 902 components) of a commercially available clamp.
The 100 Ω to 250 Ω upper & lower limits guarantee the reproducibility of the test. Since there's too many unknown factors (Power cord varies constantly, varying internal DUT impedances, etc), the ferrite size is determined experimentally to obtain an impedance between the 2 limits over the frequency band of interest.
Although the solid state clamp doesn't need to meet these requirements as a "pre-compliance" test device the objective is to do so.
The impedance of a ferrite is proportional to the ratio of the outer/inner diameter, the ferrite length and square of the number of turns.

$$Z = k.l.n^2.\ln(do/di)$$

Where:

Z = impedance
k = constant
do = Outer diameter
di = inner diameter
n = number of turns
For an existing clamp this will give us: Z = k.30.1.ln(34/20) = 15.92.k (Ω)
(Most mechanical clamps use 2 consecutive ferrites to as current pick-up to obtain the required impedance 2 x 15 mm = 30mm)

For the ferrites proposed in the previous paragraph:

$$Z = k.15.\ln(24/10) = 13.13.k \ (\Omega)$$

This figure is lower so one can reasonable assume that the impedance will be lower accordingly however the full effect isn't clear since the "integrated power cord" has different properties. The effect is also more predictable since the cord is permanently fixed inside the clamp.

If necessary the weight can be compromised by using larger ferrites or the inner diameter still lowered by using wire with a thinner insulation.

The effect on the measurement resolution in the curved positions depends on the chosen spacing and the diameter of the ferrites.

a) 50mm spacing as seen in Figure 16: The effect of the bends in this case is minimal. If the arc is taken into account in the bends the measurement resolution is consistent over the entire length of the probe. The fact that the distance between the inner core and the wires is slightly different from the straight sections has a small effect on the measurement. This can be compensated by providing a calibration plot for every individual ferrite.

b) 16mm spacing as seen in Figure 17: The effect of the bends isn't minimal anymore. The result is that the 16mm measurement resolution can't be guaranteed over the entire length of the clamp. In fact the measurement resolution reduces to the arc length of the minimum arc determined by the space available for the ferrite.

**Switch Parameters**

The ideal switch obviously would be a switch with zero switching transition time, zero insertion loss over the entire frequency band (10-1000 MHz), infinite RF isolation over the entire frequency band (10-1000 MHz), high peak power resistance and no wear.

Obviously available switches do not have ideal characteristics. The proposed switch makes use of 2 MOSFET transistors. RF MOSFET transistors have good properties to obtain the required specifications.

MOSFETS can easily produce switching transition times in the nanoseconds range. This is negligible compared to the measurement time of several milliseconds (The minimum measurement time we can achieve is 15ms per ferrite). Commercially available devices for example have typical switch-on transition times of 200ns and switch-off transition times of 90ns. This is negligible for this application.

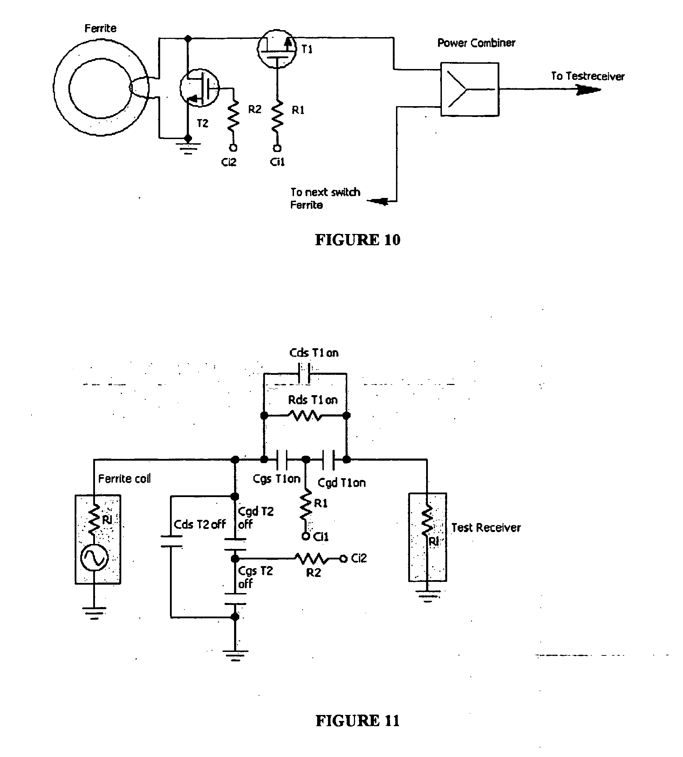

To determine the insertion loss we need to look at the equivalent AC circuit (shown in Figure 11) of the switch below (shown in Figure 10) when T1 is closed and T2 is open i.e. the ferrite/coil combination is "current probe" mode.

The insertion loss is primarily determined by Rds of T1 in switched on mode. In practice values below 10 Ω even as low as 3Ω can be achieved with MOSFET transistors.

The corresponding Insertion Loss in a 50 Ω load is $IL \approx \dfrac{10.Rds}{Rl.\ln(10)} \approx 0.87 \ Rds$

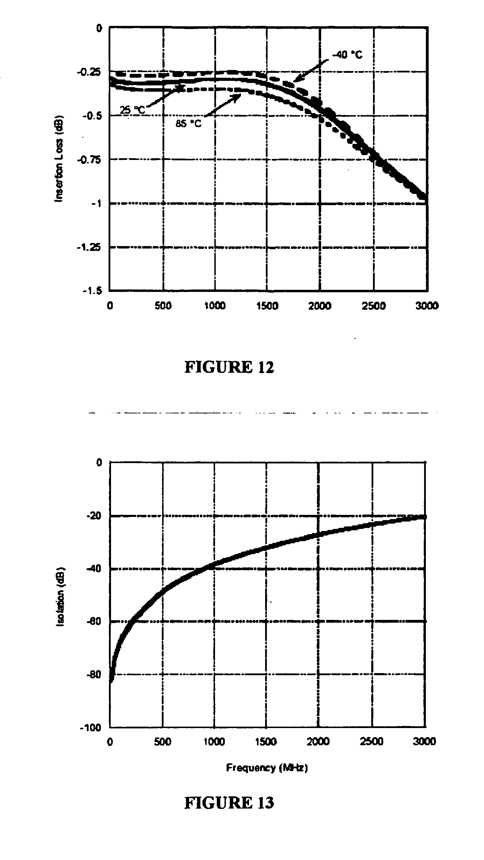

for 10 Ω is around 0.25 dB. This value is acceptable for the given application. In Figure 12 the relationship between the frequency & insertion loss of a commercially available MOSFET switch is shown. The loss within the frequency band of interest for our application (10 - 1000 MHz) does not exceed 0.5 dB

Isolation loss is usually harder to meet. Feed through of RF signals is unavoidable especially for higher frequencies. Figure 13 shows the isolation loss of an example commercially available device. The frequency band of interest is 10-1000MHz. At around 1000 MHz the value of the device is -30dB.

The EMI RF power generated by the EUT is generally very low. Nevertheless incidental high RF EMI could damage the switches. Mechanical absorbing clamps don't have any semiconductor components and as such are insensitive to high RF interference. The maximum RF input power for an R&S MDS21 is rated at 5W or 74dBm. The maximum switching power of MOSFET of suitable devices range from 5dBm - 25dBm. If necessary stacking of transistors could be considered.

Referring to the switch circuit in Figure 10, switching truth table:

| Cil | CI2 | Mode |
|-----|-----|------|
| Off | Off | Choke |
| On | Off | Current probe |
| Off | On | "Invisible" |
| On | On | N/A |

Generally other semiconductor switches may also be used for example Gallium Arsenicle (GaAs) switches.

**Cable Parameters**

The RF cable used to make the winding uses common 50 $\Omega$ semi-rigid coaxial RF cable. Preferably it has small diameter (to keep the ferrite small), small bending diameter (to allow compact assembly), high shielding effectiveness and low loss below 1GHz.

For a 30mm distance between the ferrites the following semi-rigid cable types are suitable.

- SUCOFORM® SM86 PE.

    (a) Diameter: 3.20mm
    (b) Minimum bending radius: 10mm
    (c) Shielding effectiveness: 100dB
    (d) Loss @ 1Ghz max 0.67 dB/m

- MULTIFLEX MF86.

    (a) Diameter: 2.65mm
    (b) Minimum bending radius: 6mm
    (c) Shielding effectiveness: 90dB
    (d) Loss @ 1GHz max 0. 79 dB/m

For a 16mm distance between the ferrites the following semi-rigid cable types are suitable. This type also allows further reduction of the ferrite diameter.

- SEMI-RIGID EZ 47-TP

    (e) Diameter:1.19mm
    (f) Minimum bending radius: 3.18mm
    (g) Shielding effectiveness: 120dB
    (h) Loss @ 1 Ghz max 1.3 dB/m

**Switching Sequence**

In the preferred setup tuning and proper reduction of stray capacitances and inductances in the wiring is desirable. Also the ferrite cores must provide sufficient reactance above 300 MHz. To reduce the size of the clamp it is preferable that the power cord runs as a serpent. It is preferable that in this configuration the influence of the loops on the performance is minimized. The serpentine configuration is shown in Figure 5.

To minimize interference from within the probe the entire probe is preferably DC operated. Preferably a DC supply voltage is supplied via the RF connection or via a battery. Preferably the switching control is provided via fiber optics.

(a) Pre-scanning cycle to determine the peak frequencies. This is done with the clamp in stationary position at the beginning of the power cord.

To scan the: 10 MHz - 1GHz spectrum assuming a test receiver measurement time of 10ms the total scan takes approx 20s.

Since the pre-scanning is done with a stationary clamp there's no performance improvement over a mechanical clamp / positioning unit

(b) Location of peaks with mechanical clamp:

- Existing mechanical clamp
  Specifications mechanical positioner with clamp.
- Speed v: 0.0286 m/s - 0.2 m/s
- Length s: 5000 mm

Time required for locating position of c peaks: $tsc = c \times / V$

s = required scanning length
v = clamp speed
c = Number of peak frequencies found in the pre-scanning cycle.

| ν (m/s) | s (m) | C | tsc (s) |
|---|---|---|---|
| 0.0286 | 5 | 5 | 874 |
| 0.2 | 5 | 5 | 125 |

The above table doesn't take the return time of the clamp into account. This time can't be determined as the peak power can be located anywhere over the length of the cower cord. Past experience shows that the total measurement time (including pre-scanning) can easily mount up to 1800 seconds.

(c) Location of peaks with solid state clamp:

Factors influencing the measurement time.

|     |     |     |     |
|---|---|---|---|
| (a) | Measurement speed of the Test Receiver: | Minimum 10ms | |
| (b) | Switching Transient time RF Switches: | Negligible | |
| (c) | Delays Control circuit: | Negligible | |

$tsc = n \times ts \times c$

n = Number of ferrites

ts = Measurement time

c = Number of peak frequencies found in the pre-scanning cycle.

The table below shows the time for different configurations

| n | ts (S) | c | tsc (s) |
|---|---|---|---|
| 100 | 0.015 | 5 | 5.5 |

(continued)

| n | ts (S) | c | tsc (s) |
|---|---|---|---|
| 333 | 0.011 | 5 | 18.3 |
| 100 | 0.100 | 5 | 50 |

Overall comparison:

| | *Existing mechanical Clamp* Test Time (s) | *Solid State Concept* Test Time (s) |
|---|---|---|
| Pre-scanning | 20 | 20 |
| Final Test | 400 | 50 |
| Total | 420 | 70 |
| The above table assumes an average Clamp velocity of 0.0625m/s. | | |

Thus at 50s the present invention is much faster than the prior art test which can take up to 30min. As well there is no setup time as there is nothing to assemble. Also the setup is much smaller because the power cord doesn't need to be stretched. The power cord is fixed inside the clamps so no opening and closing required. The present invention is more reliable as there are no mechanical components or assembly.

**Claims**

1. A system for measuring power disturbance generated by a piece of equipment, the system comprising:

   an electrical cable configured for connecting said equipment to a power source;
   a plurality of transformers (402, 702) positioned along the length of said cable;
   **characterised by**
   a plurality of switching devices (400, 700), each configured to connect a secondary winding of a respective transformer (402, 702) to either an open circuit, a short circuit or to a current measurement or analysis means; whereby when an operative switching device (400, 700) connects the secondary winding of operative transformer (402, 702) to said current measurement or analysis means, each switching device (400, 700) on a first side of said operative switching device connects the secondary winding of the respective transformer as short circuit and each switching device (400, 700) on the other side of said operative switching device connects the secondary winding of the respective transformer as open circuit.

2. The system as claimed in claim 1 further comprising
   control means (708) operative connected to said plurality of switching devices (700), said control means (708) being configured to automatically switch each switching device (700) in a predetermined sequence to sequentially connect all of the secondary windings of said plurality of transformers (702) to said current measurement or analysis means.

3. The system as claimed in claim 2, wherein said first side corresponds to the side connected to said equipment.

4. The system as claimed in claim 3 further comprising a housing enclosing said cable, said plurality of transformers (702) and said plurality of switching devices (700).

5. The system as claimed in claim 4, wherein said cable and said plurality of transformers (702) are arranged in a serpentine spiral or coiled configuration within said housing.

6. The system as claimed in claim 5, said current measurement or analysis means comprising a spectrum analyzer or a test receiver, said current measurement or analysis means, said spectrum analyzer or said test receiver including an input resistance, the voltage across said input resistance thereby allowing measurement or analysis of the current in said cable.

**7.** The system as claimed in claim 6, said plurality of switching devices (700) comprising a plurality of semiconductor switches or switch packages.

**8.** The system as claimed in claim 7, wherein said semiconductor switches or switch packages are MOSFET semiconductors.

**9.** The system as claimed in claim 7, wherein said semiconductor switches or switch packages are GaAs switches.

**10.** The system as claimed in claim 6, said system being further configured to perform a pre-scan using a first of said transformers (700) and a full scan over all of said plurality of transformers (700), the pre-scan and the full scan being comprised by said predetermined sequence.

**11.** The system as claimed in claim 10, the system being configured to use said spectrum analyzer or said test receiver determining peak frequencies of power disturbance during said pre-scan, said system being further configured to use said spectrum analyzer or said test receiver recording the frequency spectrum of said power disturbance between 10MHz and 1GHz during said full scan.

**Patentansprüche**

**1.** System zum Messen einer Leistungsstörung, die durch ein Stück einer Ausrüstung erzeugt wird, wobei das System folgende Merkmale aufweist:

ein elektrisches Kabel, das zum Verbinden der Ausrüstung mit einer Leistungsquelle konfiguriert ist;
eine Mehrzahl von Transformatoren (402, 702), die entlang der Länge des Kabels positioniert sind;
**gekennzeichnet durch**
eine Mehrzahl von Schaltvorrichtungen (400, 700), die jeweils konfiguriert sind, um eine Sekundärwicklung eines jeweiligen Transformators (402, 702) mit entweder einem Leerlauf, einem Kurzschluss oder mit einer Strommessungs- oder Stromanalyseeinrichtung zu verbinden;
wodurch, wenn eine betriebsfähige Schaltvorrichtung (400, 700) die Sekundärwicklung eines betriebsfähigen Transformators (402, 702) mit der Strommessungs- oder Stromanalyseeinrichtung verbindet, jede Schaltvorrichtung (400, 700) auf einer ersten Seite der betriebsfähigen Schaltvorrichtung die Sekundärwicklung des jeweiligen Transformators als einen Kurzschluss verbindet und jede Schaltvorrichtung (400, 700) auf der anderen Seite der betriebsfähigen Schaltvorrichtung die Sekundärwicklung des jeweiligen Transformators als einen Leerlauf verbindet.

**2.** System nach Anspruch 1, ferner mit
einer Steuereinrichtung (708), die mit der Mehrzahl von Schaltvorrichtungen (700) betriebsfähig verbunden ist, wobei die Steuereinrichtung (708) konfiguriert ist, um jede Schaltvorrichtung (700) in einer vorbestimmten Folge automatisch zu schalten, um alle Sekundärwicklungen der Mehrzahl von Transformatoren (702) mit der Strommessungs- oder Stromanalyseeinrichtung aufeinander folgend zu verbinden.

**3.** System nach Anspruch 2, bei dem die erste Seite der Seite, die mit der Ausrüstung verbunden ist, entspricht.

**4.** System nach Anspruch 3, ferner mit einem Gehäuse, das das Kabel, die Mehrzahl von Transformatoren (702) und die Mehrzahl von Schaltvorrichtungen (700) umschließt.

**5.** System nach Anspruch 4, bei dem das Kabel und die Mehrzahl von Transformatoren (702) in einer geschlängelten Spirale oder einer gewundenen Konfiguration innerhalb des Gehäuses angeordnet sind.

**6.** System nach Anspruch 5, wobei die Strommessungs- oder Stromanalyseeinrichtung einen Spektrumanalysator oder einen Prüfempfänger aufweist, wobei die Strommessungs- oder Stromanalyseeinrichtung, der Spektrumanalysator oder der Prüfempfänger einen Eingangswiderstand umfasst, wobei die Spannung über den Eingangswiderstand **dadurch** eine Messung oder eine Analyse des Stroms in dem Kabel erlaubt.

**7.** System nach Anspruch 6, wobei die Mehrzahl von Schaltvorrichtungen (700) eine Mehrzahl von Halbleiterschaltern oder Schaltpaketen aufweist.

**8.** System nach Anspruch 7, bei dem die Halbleiterschalter oder die Schaltpakete MOSFET-Halbleiter sind.

**9.** System nach Anspruch 7, bei dem die Halbleiterschalter oder die Schaltpakete GaAs-Schalter sind.

**10.** System nach Anspruch 6, wobei das System ferner konfiguriert ist, um eine Vorabtastung unter Verwendung eines ersten der Transformatoren (700) und eine vollständige Abtastung über alle der Mehrzahl von Transformatoren (700) durchzuführen, wobei die vorbestimmte Folge die Vorabtastung und die vollständige Abtastung aufweist.

**11.** System nach Anspruch 10, wobei das System konfiguriert ist, um den Spektrumanalysator oder den Prüfempfänger, der Spitzenfrequenzen einer Leistungsstörung bestimmt, während der Vorabtastung zu verwenden, wobei das System ferner konfiguriert ist, um den Spektrumanalysator oder den Prüfempfänger, der das Frequenzspektrum der Leistungsstörung zwischen 10MHz und 1GHz aufzeichnet, während der vollständigen Abtastung zu verwenden.

**Revendications**

**1.** Système pour mesurer la perturbation de puissance générée par un équipement, le système comprenant :

un câble électrique configuré pour connecter ledit équipement à une source de puissance ;
une pluralité de transformateurs (402, 702) positionnés sur la longueur dudit câble ;
**caractérisé par** une pluralité de dispositifs de commutation (400, 700), chacun configuré pour connecter un enroulement secondaire d'un transformateur respectif (402, 702) soit à un circuit ouvert, un court-circuit, ou à des moyens d'analyse ou de mesure du courant ;
moyennant quoi, lorsqu'un dispositif de commutation opérant (400, 700) connecte l'enroulement secondaire d'un transformateur opérant (402, 702) auxdits moyens d'analyse ou de mesure de courant, chaque dispositif de commutation (400, 700) sur un premier côté dudit dispositif de commutation opérant connecte l'enroulement secondaire du transformateur respectif en court-circuit et chaque dispositif de commutation (400, 700) de l'autre côté dudit dispositif de commutation opérant connecte le second enroulement du transformateur respectif en tant que circuit ouvert.

**2.** Système selon la revendication 1, comprenant en outre des moyens de commande (708) opérants, connectés à ladite pluralité de dispositifs de commutation (700), lesdits moyens de commande (708) étant configurés pour commuter automatiquement chaque dispositif de commutation (700) dans une séquence prédéterminée pour connecter séquentiellement tous les enroulements secondaires de ladite pluralité de transformateurs (702) auxdits moyens d'analyse ou de mesure du courant.

**3.** Système selon la revendication 2, dans lequel ledit premier côté correspond au côté connecté à l'équipement.

**4.** Système selon la revendication 3, comprenant en outre un logement renfermant ledit câble, ladite pluralité de transformateurs (702) et ladite pluralité de dispositifs de commutation (700).

**5.** Système selon la revendication 4, dans lequel ledit câble et ladite pluralité de transformateurs (702) sont disposés en configuration enroulée ou en spirale formant serpentin à l'intérieur du logement.

**6.** Système selon la revendication 5, lesdits moyens d'analyse ou de mesure de courant comprenant un analyseur de spectre ou un récepteur de test, lesdits moyens d'analyse ou de mesure de courant, ledit analyseur de spectre ou ledit récepteur de test comprenant une résistance d'entrée, la tension sur ladite résistance d'entrée permettant ainsi la mesure ou l'analyse du courant dans ledit câble.

**7.** Système tel que défini dans la revendication 6, ladite pluralité de dispositifs de commutation (700) comprenant une pluralité de commutateurs à semi-conducteurs ou d'ensembles de commutateurs.

**8.** Système selon la revendication 7, dans lequel lesdits commutateurs à semi-conducteurs ou ensembles de commutateurs sont des semi-conducteurs MOSFET.

**9.** Système selon la revendication 7, dans lequel lesdits commutateurs à semi-conducteurs ou ensembles de commutateurs sont des commutateurs GaAs.

**10.** Système selon la revendication 6, ledit système étant de plus configuré pour effectuer un pré-scannage en utilisant un premier desdits transformateurs (700) et un scannage complet sur la totalité de ladite pluralité de transformateurs (700), le pré-scannage et le scannage complet étant constitués par ladite séquence prédéterminée.

**11.** Système selon la revendication 10, le système étant configuré pour utiliser ledit analyseur de spectre ou ledit récepteur de test déterminant des fréquences de pointe de ladite perturbation de puissance pendant ledit pré-scannage, ledit système étant de plus configuré pour utiliser ledit analyseur de spectre ou ledit récepteur de test enregistrant le spectre de fréquence de ladite perturbation de puissance entre 10 MHz et 1 GHz pendant ledit scannage complet.

**FIGURE 1**

**FIGURE 2**

**FIGURE 3**

402

400

404 408 406

**FIGURE 4**

**FIGURE 5**

**FIGURE 6**

**FIGURE 7**

EP 1 701 171 B1

Distance 16 mm
cable diameter 4mm
Ø 10mm Ø 24mm
Weight Ferrites: 9 kg
Resolution: 16 mm

Distance 50 mm
cable diameter 4mm
Ø 10mm Ø 24mm
Ferrite Dimensions
Power Leads 2.5 mm³
Weight Ferrites 2.7 kg
Resolution: 50 mm

FIGURE 8

Ohms    Input Resistance & Reactance
300
250
200
150
100
50
0
10⁷    Frequency Hz    10⁸    10⁹

900
902

FIGURE 9

18

**FIGURE 10**

**FIGURE 11**

**FIGURE 12**

Frequency (MHz)

**FIGURE 13**

**FIGURE 14**

Ferrite n-1 in current
transformer mode

Ferrite n-1 in "invisible" mode

Ferrite n-1

Ferrite n in absorber "choke" mode

Ferrite n in current
transformer mode

Ferrite n in "invisible" mode

Ferrite n

Ferrite n+1 in absorber
"choke" mode

Ferrite n+1 in current
transformer mode

Ferrite n+1

tr    tm    ta   tf

Switching time On    tr = 200 ns
Acquire Reading      ta = 50μs
Measurement time     tm = 15 ms
Switching time Off   tf = 90ns

**FIGURE 15**

50 mm

50 mm    50 mm

50 mm    50 mm

**FIGURE 16**

Arc lenght

16mm

**FIGURE 17**

22

**EP 1 701 171 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- GB 2359934 A